# EUROPÄISCHE PATENTSCHRIFT

(11) **EP 1 500 196 B1**
(45) Veröffentlichungstag und Bekanntmachung des Hinweises auf die Patenterteilung: **09.11.2011**
(21) Anmeldenummer: 03727329.9
(22) Anmeldetag: 17.04.2003
(51) Int. Cl.: H03K 17/16

(54) **HALBBRÜCKENSCHALTUNG**
HALF-BRIDGE CIRCUIT
CIRCUIT EN DEMI-PONT

(30) Priorität: 02.05.2002 DE 10219760
(43) Veröffentlichungstag der Anmeldung: 26.01.2005
(73) Patentinhaber: Infineon Technologies AG, 85579 Neubiberg (DE)
(72) Erfinder: MUENZER, Mark, Nils, 59494 Soest (DE); TSCHIRBS, Roman, 59494 Soest (DE)
(74) Vertreter: Schmuckermaier, Bernhard
(86) Internationale Anmeldenummer: PCT/EP2003/004096
(87) Internationale Veröffentlichungsnummer: WO 2003/094351

(56) Entgegenhaltungen:
- EP-A- 0 278 432
- EP-A- 0 621 635
- US-A- 4 493 017
- US-A- 5 929 519

## Beschreibung

Die Erfindung betrifft eine Halbbrückenschaltung gemäß dem Oberbegriff des Anspruchs 1.

Halbbrückenschaltungen werden ganz allgemein zur Erzeugung eines Wechselsignals aus einer eingangseitig zugeführten Gleichspannung verwendet. Bei entsprechender Verschaltung können derartige Halbbrückenschaltungen auch zur Erzeugung mehrphasiger Wechselsignale, insbesondere auch von dreiphasigen Drehstromsignalen, verwendet werden. Das ausgangsseitige (ggf. mehrphasige) Wechselsignal wird dann beispielsweise einem Motor zugeführt. Andere Ausführungen von Halbbrückenschaltungen dienen als Invertierer. Ebenfalls einen Motor steuert der 3-Ebenen-Invertierer in US 5,929,519. Auch werden Halbbrücken als Schaltungen aus alternativ leitenden leistungsschaltenden Bauelementen in Transformatoren benutzt (US 4,493,017).

Halbbrückenschaltungen sind gemäß dem Stand der Technik in einer Vielzahl von Abwandlungen bekannt. Halbbrückenschaltungen, von denen die Erfindung ausgeht, basieren im wesentlichen auf zwei Leistungstransistoren sowie zwei Dioden, welche üblicherweise jeweils auf einem einzigen Chip integriert sind. Als Leistungstransistoren kommen dabei vorzugsweise aufgrund deren geringen Steuerleistungen sowie deren geringen Durchlasswiderständen auf der Kollektor-Emitter-Strecke sogenannte Insulated Gate Bipolartransistoren (IGBTs) zur Anwendung. Für kleinere Leistungen werden auch Feldeffektleistungstransistoren, vorzugsweise MOSFETs, eingesetzt.

Eingangsseitig sind die Leistungstransistoren dabei mit ihren Durchlassstrompfaden, d.h. deren Source-Drain-Strecken bzw. deren Kollektor-Emitter-Strecken, in Reihe geschaltet. In gegensinniger Polung ist den beiden Leistungstransistoren dabei jeweils eine Diode parallel geschaltet. Konkret bedeutet dies, dass bei Verwendung von npn-IGBTs jeweils die Kollektorelektrode eines IGBTs mit der entsprechenden Kathode der parallel geschalteten Diode und die Emitterelektrode des IGBTs mit der Anode der entsprechenden parallel geschalteten Diode verbunden ist. Der Phasenausgang, an welcher die Wechselspannung abgegriffen werden kann, liegt an dem Knotenpunkt zwischen den beiden in Reihe geschalteten Leistungstransistoren.

Im Kurzschlussfall ist es zur Begrenzung der Abschaltgeschwindigkeit erwünscht, das Ansteuersignal der Leistungstransistoren möglichst stark gegenzukoppeln. Im Normalbetriebsfall ist jedoch eine zu starke Gegenkopplung mit erhöhten Verlusten verbunden, was unerwünscht ist.

Zur Erzeugung einer derartigen Gegenkopplung des Ansteuersignals wird dieses daher gemäß dem Stand der Technik nicht unmittelbar an die entsprechenden Steuereingänge (insbesondere Gate und Source bzw. Gate und Emitter in den o.a. Ausführungsvarianten) der - zunächst als ideal angenommen - diskreten Leistungstransistoren angelegt, sondern über jeweils in den Durchlassstrompfaden der beiden Leistungstransistoren angeordnete Induktivitäten. Die in den Durchlassstrompfaden hinter den Induktivitäten angeordneten Steuereingänge werden wie in EP 0 621 635 im Allgemeinen als Hilfselektroden, z.B. als Hilfsourceelektrode bzw. als Hilfsemitter, bezeichnet. Die gewählten Werte der Induktivitäten stellen gemäß dem Stand der Technik hinsichtlich der induktiven Gegenkopplung einen Kompromiss zwischen einer Begrenzung von Schaltverlusten im Normalbetrieb und einer Begrenzung der Abschaltgeschwindigkeit des entsprechenden Leistungs (Schalt-) transistors im Kurzschlussfall dar.

In der Praxis macht man sich zunutze, dass in der oben beschriebenen Halbbrückenschaltung jede Leitungsstrecke, d.h. jede Leiterbahn und jede mit Hilfe von Bonddrähten oder dergleichen realisierte Verbindung, zwischen den einzelnen - zunächst als ideal angenommenen - diskreten Bauelementen, nämlich den Leistungstransistoren und den Dioden, eine (Leitungs-/Streu-) Induktivität darstellt, wobei jede dieser Induktivitäten ggf. im Hinblick auf den konkreten Anwendungsfall in weitem Umfang in ihrer Größe vorgebbar ist. Die Leitungsinduktivitäten nutzt die Inverterschaltung in EP 0278 432. Bei einem Stromanstieg in der Laststromleitung wird eine Gegenspannung in der Steuerstromleitung induziert. Durch geeignete Anordnung der entsprechenden (Hilfs-)Elektroden (z.B. Hilfssourceelektrode bzw. Hilfsemitter) in den jeweiligen von den Elektroden (z.B. Source bzw. Emitter) wegführenden Leitungsstrecken läßt sich damit die Größe der für die Gegenkopplung notwendigen Induktivitäten bzw. der Grad der jeweiligen Gegenkopplung festlegen.

Zur Verdeutlichung des oben angegebenen Sachverhalts wird beispielhaft auf eine in der Zeichnungsfigur 3 skizzierte konkrete Ausführungsform einer Halbbrückenschaltung gemäß dem Stand der Technik Bezug genommen.

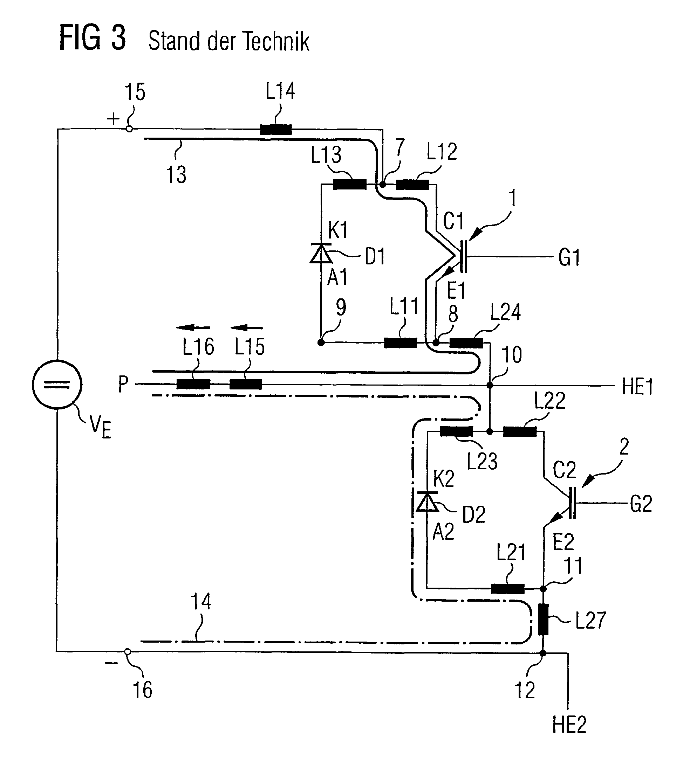

Die Figur 3 zeigt ein Ersatzschaltbild einer Halbbrückenschaltung gemäß dem Stand der Technik basierend auf zwei IGBTs und zwei Dioden. Dem Ersatzschaltbild entnimmt man dabei neben den diese (idealen) Bauteile symbolisierenden Schaltzeichen auch - durch entsprechende diskrete Schaltzeichen gekennzeichnet- die in jeder Zuleitung implizit oder intendiert vorhandenen (parasitären) Streu- und/oder Leitungsinduktivitäten.

Die Halbbrückenschaltung gemäß der Figur 3 weist zwei Eingangsklemmen 15 und 16 auf, über welche eine Eingangsgleichspannung V_{E} zuführbar ist, sowie einen Phasenausgang P, an welchem die erzeugte Wechselspannung abgreifbar ist. Dieser Phasenausgang P stellt beispielsweise eine Phase eines dreiphasigen Drehstromnetzes dar.

Die erste Eingangsklemme 15 ist über die (Streu-)Induktivität L14 mit dem Knoten 7 verbunden. Der Knoten 7 ist einerseits über die (Streu-)Induktivität L12 mit dem Kollektor C1 des ersten Insulated Gate Bipolartransistors 1 und andererseits über die (Streu-)Induktivität L13 mit der Kathode K1 der ersten Diode D1 verbunden. Der Emitter E1 des ersten Insulated Gate Bipolartransistors 1 ist auf den Knoten 8 geführt. Ferner ist die Anode A1 der Diode D1 mit dem Knoten 9 und dieser wiederum über die (Streu-) Induktivität L11 mit dem Knoten 8 verbunden. Der Knoten 8 wiederum ist über die (Streu-)Induktivität L24 auf den Knoten 10 geführt. Dieser Knoten 10 bildet gemäß dem Stand der Technik einerseits den Anschlusspunkt für den Phasenausgang P, dessen (Leitungs-/Streu-)Induktivitäten in der in Rede stehenden Zeichnungsfigur durch entsprechende mit den Bezugszeichen L15 und L16 gekennzeichnete Schaltzeichen symbolisiert sind, und andererseits den Anschlusspunkt für den zweiten in Reihe geschalteten Leistungs-/Schalttransistor (IGBT 2).

Leitungs- bzw. Streuinduktivitäten berücksichtigend stellt der Knoten 10 einerseits über die (Streu-) Induktivität L22 eine Verbindung zum Kollektoranschluss C2 des zweiten Insulated Gate Bipolartransistors 2 und andererseits über die (Streu-) Induktivität L23 zur Kathode K2 der zweiten Diode D2 her. Der Emitter E2 des zweiten Insulated Gate Bipolartransistors 2 ist auf den Knoten 11 geführt. Die Anode A2 der zweiten Diode D2 ist über die (Streu-)Induktivität L21 ebenfalls mit dem Knoten 11 verbunden. Vom Knoten 11 wiederum führt eine Leitung repräsentiert durch die Induktivität L27 weg auf den Knoten 12 und von dort weiter zur Eingangsklemme 16.

Um die vorgenannte erwünschte Gegenkopplung zu erhalten, werden die Ansteuersignale für die beiden Insulated Gate Bipolartransistoren 1, 2 nicht unmittelbar zwischen die jeweiligen Steueranschlüsse Gate G1 bzw. G2 und Emitter E1 bzw. E2 der Insulated Gate Bipolartransistoren 1 bzw. 2 geschaltet, sondern es erfolgt eine Ansteuersignaleinkopplung weiter von diesen Steueranschlüssen Gate G1 bzw. G2 und Emitter E1 bzw. E2 entfernt auf den vorhandenen Verbindungsstrecken zwischen dem Emitter E1 des ersten Insulated Gate Bipolartransistors 1 und dem Kollektor C2 des zweiten Insulated Gate Bipolartransistors 2 bzw. zwischen dem Emitter E2 des zweiten Insulated Gate Bipolartransistors 2 und der Eingangsklemme 16. Die entsprechenden in der Fachsprache auch als Hilfsemitter bezeichneten Anschlusspunkte sind in der Figur 3 durch die Bezugszeichen HE1 (Hilfsemitter des IGBT 1) und HE2 (Hilfsemitter des IGBT2) gekennzeichnet. Demnach befindet sich der Hilfsemitter HE1 des ersten Insulated Gate Bipolartransistors 1 unmittelbar am Knotenpunkt 10, an welchen sich der Phasenausgang P anschließt, und der Hilfsemitter HE2 des zweiten Insulated Gate Bipolartransistors 2 am Knotenpunkt 12, der wiederum eine Verbindung zur Eingangsklemme 16 herstellt.

Die Figur 3 zeigt die Kommutierung einer eingangsseitig zugeführten Gleichspannung V_{E} im Normalbetrieb der Halbbrückenschaltung.. Demnach fließt aufgrund der an der ersten Eingangsklemme 15 anliegende positive Spannung + bei in Durchlass geschaltetem erstem Insulated Gate Bipolartransistors 1 ein Strom längs des mit dem Bezugszeichen 13 in der Zeichnungsfigur gekennzeichneten Strompfades auf den Phasenausgang P: Der Strompfad verläuft entsprechend der Figur 3 über die Induktivität L14, den Knoten 7, die Induktivität L12, die Kollektor-Emitter-Strecke C1-E1 des Insulated Gate Bipolartransistors 1, den Knoten 8, die Induktivität L24, den Knoten 10 zum Phasenausgang P.

Beim Abschalten des ersten Insulated Gate Bipolartransistors 1 wird nach der Regel von Lenz der auf den Phasenausgang P zufließende Strom zunächst weiterfließen. Da der Strompfad 3 zur positiven Klemme 15 jedoch durch den abgeschalteten IGBT 1 unterbrochen ist, kommutiert der Strom auf den mit dem Bezugszeichen 14 gekennzeichneten Strompfad. Demnach wird die zweiten Eingangsklemme 16 (negativer Spannungspol - der Eingangsgleichspannung V_{E}) bei gesperrtem erstem Insulated Gate Bipolartransistors 1 über den Knoten 12, die Induktivität L27, den Knoten 11, die Induktivität L21, die in Durchlassrichtung geschaltete Diode D2, die Induktivität L23, den Knoten 10 mit dem Phasenausgang P verbunden.

Beim regulären Kommutierungsvorgang ändert sich daher die Stromstärke in den Gegenkopplungsinduktivitäten L24 und L27. Es findet demnach eine mit unerwünschten Schaltverlusten verbundene Gegenkopplung statt.

Ähnliches gilt für den Fall eines Phasenkurzschlusses. Nimmt man beispielhaft an, dass zwischen dem Phasenausgang P und der zweiten Eingangsklemme 16 ein Kurzschluss besteht. In diesem Fall wird ein Strom bei in Durchlass geschaltetem IGBT 1 von der positiven Eingangsklemme 15 über die Induktivität L14, den Knoten 7, die Induktivität L12, die Kollektor-Emitter-Strecke C1-E1 des IGBT 1, die Induktivität L24, den Knoten 10, die Induktivität L15 und den Kurzschlusspfad auf die negative Eingangsklemme 16 fließen.

Beim Abschalten des ersten Insulated Gate Bipolartransistors 1 ändert sich die Stromstärke in der Induktivität L24. Es findet demnach die in diesem Fall gewünschte Gegenkopplung zur Begrenzung der Abschaltgeschwindigkeit des ersten Insulated Gate Bipolartransistors 1 statt.

Obwohl sich die vorgenannte Ausführungsform dem Grunde nach bewährt hat, führt die für den Kurzschlussfall zur Begrenzung ihrer Abschaltgeschwindigkeit notwendige Gegenkopplung der Ansteuerung der beiden Schalttransistoren zu Schaltverlusten im Normalbetrieb der Halbbrückenschaltung.

Der Erfindung liegt somit die Aufgabe zugrunde, eine an sich bekannte Halbbrückenschaltung derart auszugestalten und weiterzubilden, dass Schaltverluste im Normalbetrieb der Halbbrückenschaltung weiter reduziert werden, ohne dass im Phasenkurzschlussfall auf eine Begrenzung der Abschaltgeschwindigkeit der Schalttransistoren verzichtet wird.

Diese Aufgabe wird bei einer gattungsgemäßen Halbbrückenschaltung durch die Merkmale des kennzeichnenden Teils des Anspruches 1 erfindungsgemäß gelöst.

Vorteilhafte Ausführungen und Weiterbildungen der Erfindung sind in den Unteransprüchen angegeben.

Der wesentliche Gedanke der Erfindung besteht darin, die vorgenannte Hilfselektrode des ersten Schalttransistors nicht wie gemäß dem Stand der Technik auf der Verbindungsleitung zwischen der zweiten Elektrode des ersten Schalttransistors (Emitter oder Source in den o.a. Beispielen) und der ersten Elektrode des zweiten Schalttransistors (i.e. Kollektor oder Drain) anzubinden, sondern an der eine Induktivität aufweisenden Leitung zum Phasenausgang. Dadurch wird erreicht, dass sich die für die induktive Gegenkopplung bei einem Phasenkurzschluss notwendige (Leitungs-)Induktivität im Normalbetrieb stets im Strompfad befindet und keine schnelle Stromänderung erfährt. Im Normalbetrieb findet demzufolge keine zeitliche Stromstärkeänderung durch das Schalten des ersten Schalttransistors statt und somit keine induktive Gegenkopplung. Bei einem Phasenkurzschluss hingegen liegt die (Leitungs-)Induktivität in dem abzuschaltenden Strompfad, so dass hier beim Abschalten des Schalttransistors eine induktive Gegenkopplung wirkt.

Eine besonders vorteilhafte Ausführungsvariante der Erfindung sieht vor, dass die Anbindung der Hilfselektrode des ersten Schalttransistors an der Leitung zum Phasenausgang gerade bei dem Abstand von der zweiten Elektrode des ersten Schalttransistors erfolgt, an dem der Wert der in der Verbindungsstrecke zwischen der zweiten Elektrode des ersten Schalttransistors und der Hilfselektrode des ersten Schalttransistors liegenden Induktivität gerade dem Wert entspricht, der für eine vorgegebene Begrenzung der Abschaltgeschwindigkeit des ersten Schalttransistors durch eine induktive Gegenkopplung notwendig ist. Ein besonderes diskretes Bauteil braucht also nicht vorgesehen zu werden. Es genügt die Wahl eines günstigen Anschlusspunkts unter Berücksichtigung der Leitungs-/Streuinduktivität der an die zweite Elektrode angeschlossenen Phasenausgangsleitung.

Erfindungsgemäß ist vorgesehen, dass die Leitung zum Phasenausgang im wesentlichen unmittelbar an der zweiten Elektrode des ersten Schalttransistors angebunden ist. Durch diese Maßnahme wird verhindert, dass sich weiterhin wie gemäß dem Stand der Technik Streu- und/oder Leitungsinduktivitäten im (Normalbetriebs-) Kommutierungskreis befinden.

Erfindungsgemäß ist ferner vorgesehen, dass die Anode der ersten Diode unmittelbar an der Hilfselektrode des ersten Schalttransistors angebunden ist. Durch diese Maßnahme lassen sich die Verluste im Normalbetrieb weiter reduzieren.

Ein Ausführungsbeispiel der Erfindung ist in der Zeichnung dargestellt und wird im folgenden näher beschrieben. Es zeigen:
- Figur 1: - ein Ersatzschaltbild einer erfindungsgemäßen Halbbrückenschaltung mit im Kurzschlussfall wirksamer Gegenkopplung - Normalbetriebszustand -
- Figur 2: - ein Ersatzschaltbild der erfindungsgemäßen Halbbrückenschaltung mit im Kurzschlussfall wirksamer Gegenkopplung gemäß der Figur 1 bei Kurzschluss zwischen dem Phasenausgang und einem Eingangszweig
- Figur 3: - ein Ersatzschaltbild einer Halbbrückenschaltung gemäß dem Stand der Technik - Normalbetriebszustand -

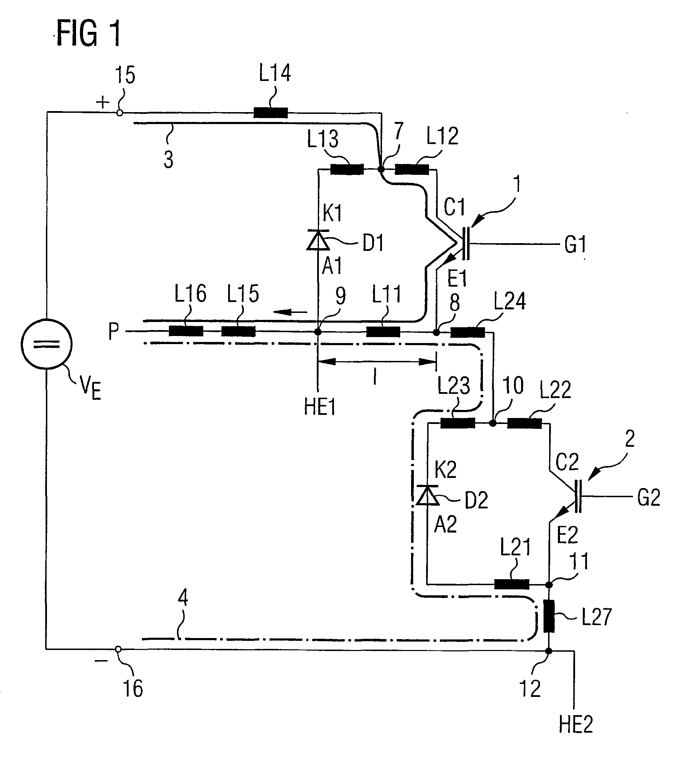

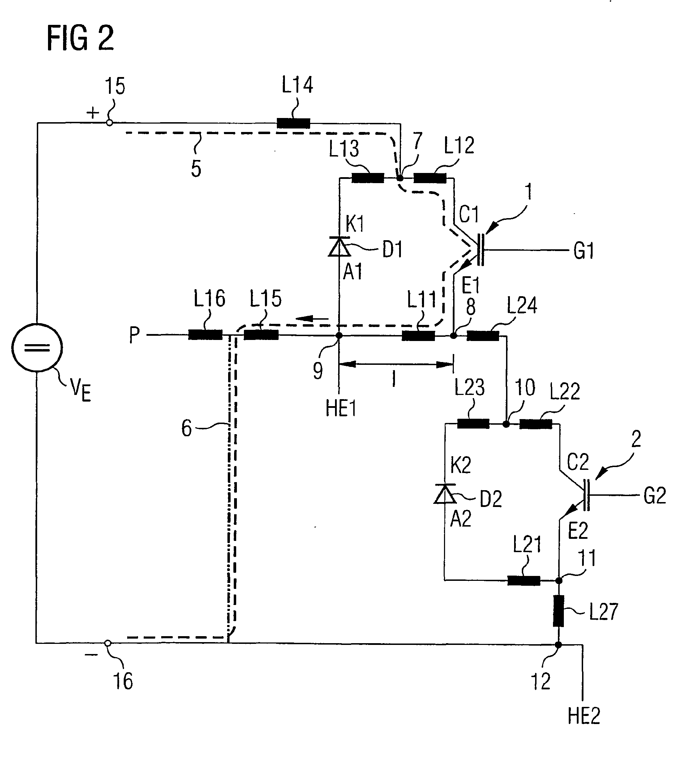

Die Figuren 1 und 2 zeigen eine erfindungsgemäße Modifikation der in der Figur 3 dargestellten und oben im Detail beschriebenen Halbbrückenschaltung gemäß dem Stand der Technik. Die in allen Zeichnungsfiguren 1 bis 3 identisch vorliegenden Einzelkomponenten der Halbbrückenschaltungen sind zum erleichterten Verständnis als mit gleichen Bezugszeichen versehene Schaltzeichen dargestellt. Wie in der Zeichnungsfigur 3 sind auch hier die vorhandenen Streu- und Leitungsinduktivitäten durch Schaltzeichen diskreter Spulen symbolisiert.

Demnach weist die auf zwei Insulated Gate Bipolartransistoren und zwei Dioden basierende Halbbrückenschaltung gemäß den Figuren 1 und 2 zwei Eingangsklemmen 15 und 16 auf, über welche eine Eingangsgleichspannung V_{E} zuführbar ist, und einen Phasenausgang P, an welchem eine Wechselspannung abgreifbar ist.

Die erste Eingangsklemme 15 ist über die (Leitungs-/Streu-) Induktivität L14 mit dem Knoten 7 verbunden. Der Knoten 7 ist einerseits über die (Leitungs-/Streu-)Induktivität L12 mit dem Kollektor C1 des ersten Insulated Gate npn-Bipolartransistors 1 verbunden und andererseits über die (Leitungs-/Streu-) Induktivität L13 mit der Kathode K1 der ersten Diode D1. Der Emitter E1 des ersten Insulated Gate npn-Bipolartransistors 1 ist auf den Knoten 8 geführt.

Der Knoten 8 ist einerseits über die (Streu-)Induktivität L24 auf den Knoten 10 geführt, andererseits schließt sich an den Knoten 8 die Leitung zum Phasenausgang P an. Die Leitung zum Phasenausgang P ist durch drei in Reihe geschaltete diskrete Induktivitäten L11, L15 und L16 symbolisiert. Zwischen den Induktivitäten L11 und L15 befindet sich der Knoten 9, welcher mit der Anode A1 der ersten Diode D1 verbunden ist.

Dieser Knoten 10 bildet den Anschlusspunkt für den zweiten in Reihe geschalteten Leistungs-/Schalttransistor (IGBT 2).

Leitungs- bzw. Streuinduktivitäten berücksichtigend stellt der Knoten 10 entsprechend dem Ausführungsbeispiel gemäß dem Stand der Technik einerseits über die (Streu-)Induktivität L22 eine Verbindung zum Kollektoranschluss C2 des zweiten Insulated Gate npn-Bipolartransistors 2 und andererseits über die (Leitungs-/Streu-) Induktivität L23 zur Kathode K2 der zweiten Diode D2 her. Der Emitter E2 des zweiten Insulated Gate npn-Bipolartransistors 2 ist auf den Knoten 11 geführt. Die Anode A2 der zweiten Diode D2 ist über die (Leitungs-/Streu-) Induktivität L21 ebenfalls mit dem Knoten 11 verbunden. Vom Knoten 11 wiederum führt eine Leitung repräsentiert durch die Induktivität L27 weg auf den Knoten 12 und von dort weiter zur Eingangsklemme 16.

Der Hilfsemitter HE2 des zweiten Insulated Gate npn-Bipolartransistors 2 befindet sich wie beim Ausführungsbeispiel gemäß dem Stand der Technik am Knotenpunkt 12, der wiederum eine Verbindung zur Eingangsklemme 16 herstellt.

Der Hilfsemitter HE1 des ersten Insulated Gate Bipolartransistors 1 befindet sich jetzt dagegen nicht mehr unmittelbar am Knotenpunkt 10 wie beim Ausführungsbeispiel gemäß der Figur 3, sondern am Knoten 9 in der Leitung zum Phasenausgang P.

Die Figur 1 zeigt einen Normalbetriebsfall der Halbbrückenschaltung, der Kommutierung einer eingangsseitig zugeführten Gleichspannung V_{E}. Demnach wird aufgrund der an der ersten Eingangsklemme 15 anliegenden positiven Spannung + bei in Durchlass geschaltetem erstem Insulated Gate npn-Bipolartransistor 1 ein Strom längs des mit dem Bezugszeichen 3 in der Zeichnungsfigur 1 gekennzeichneten Strompfades auf den Phasenausgang P geführt: Der Strompfad 3 verläuft entsprechend der Figur 1 über die Induktivität L14, den Knoten 7, die Induktivität L12, die Kollektor-Emitter-Strecke C1-E1 des ersten Insulated Gate Bipolartransistors 1, den Knoten 8, die Induktivität L11, den Knoten 9 und die Induktivitäten L15, L16 zum Phasenausgang P.

Beim Abschalten des ersten Insulated Gate npn-Bipolartransistors 1 kommutiert der Strom auf den mit dem Bezugszeichen 4 gekennzeichneten Strompfad. Demnach wird der an der zweiten Eingangsklemme 16 angeschlossene negative Pol - der Eingansspannung V_{E} bei gesperrtem erstem Insulated Gate npn-Bipolartransistors 1 über den Knoten 12, die Induktivität L27, den Knoten 11, die Induktivität L21, die in Durchlassrichtung geschaltete Diode D2, die Induktivität L23, den Knoten 10, die Induktivität L24, den Knoten 8, die Induktivität L11, den Knoten 9 und die Induktivitäten L15, L16 mit dem Phasenausgang P verbunden. Aufgrund der Lenz'schen Regel wird der Strom zum Phasenausgang P dabei aufrechterhalten und es fließt ein Strom längs des Strompfades 4.

Beim regulären Kommutierungsvorgang befindet sich diese Induktivität L11 nicht zwischen der Klemme 15 und dem Knoten 8 im Strompfad 3 bzw. zwischen der Klemme 16 und dem Knoten 8 im Strompfade 4, d.h. in Teilen der vorerwähnten Strompfade 3 oder 4, in denen sich die Stromstärke schnell ändert. Vielmehr befindet sich diese Induktivität L11 in einem Leitungsabschnitt, der beide Strompfade 3 und 4 umfasst. In diesem Leitungsabschnitt zwischen dem Knoten 8 und dem Phasenausgang P ändert sich die Stromstärke in der Gegenkopplungsinduktivität L11 nicht. Es findet hier demnach keine mit Schaltverlusten verbundene Gegenkopplung statt.

Für den in der Figur 2 dargestellten Fall, dass zwischen der zum Phasenausgang P führenden Leitung und der zweiten Eingangsklemme 16 ein Kurzschluss entsteht, wird der positive Pol + der Eingangsgleichspannungsquelle V_{E} bei in Durchlass geschaltetem IGBT 1 über die Induktivität L14, den Knoten 7, die Induktivität L12, die Kollektor-Emitter-Strecke C1-E1 des IGBT 1, die Induktivität L11, den Knoten 9, die Induktivität L15 und den Kurzschlusspfad 6, die Eingangsklemme 16 mit dem negativen Pol - der Eingangsgleichspannungsquelle V_{E} verbunden. Es findet ein Stromfluss längs dem mit dem Bezugszeichen 5 gekennzeichneten Strompfad statt.

Bei Unterbrechungen in der in diesem Strompfad liegenden Leitungsteile, z. B. beim Abschalten des ersten Insulated Gate Bipolartransistors 1, ändert sich die Stromstärke in der Induktivität L11 schnell. Es findet eine in diesem Fall gewünschte Gegenkopplung zur Begrenzung der Abschaltgeschwindigkeit des ersten Insulated Gate npn-Bipolartransistors 1 statt.

Es sei darauf hingewiesen, dass die Anbindung des Hilfsemitters HE1 des ersten Insulated Gate npn-Bipolartransistors 1 an der Leitung zum Phasenausgang P gerade bei dem Abstand 1 Emitter E1 des ersten Insulated Gate npn-Bipolartransistors 1 erfolgt, an dem der Wert der in der Verbindungsstrecke zwischen dem Emitter E1 des ersten Insulated Gate npn-Bipolartransistors 1 und des Hilfsemitters HE1 des ersten Insulated Gate npn-Bipolartransistors 1 liegenden Induktivität L11 gerade dem Wert entspricht, der für eine vorgegebene Begrenzung der Abschaltgeschwindigkeit des ersten Insulated Gate Bipolartransistors 1 durch eine induktive Gegenkopplung notwendig ist.

### Bezugszeichenliste

- 1: erster Insulated Gate Bipolartransistor
- 2: zweiter Insulated Gate Bipolartransistor
- 3: erster Strompfad
- 4: zweiter Strompfad
- 5: dritter Strompfad
- 6: Kurzschlusspfad
- 7: Knoten
- 8: Knoten
- 9: Knoten
- 10: Knoten
- 11: Knoten
- 12: Knoten
- 13: erster Strompfad
- 14: zweiter Strompfad
- 15: erste Eingangsklemme
- 16: zweite Eingangsklemme

- P: Phasenausgang
- V_{E}: Eingangsgleichspannungsquelle (Zwischenkreis)
- +: positiver Pol der Eingangsgleichspannungsquelle
- -: negativer Pol der Eingangsgleichspannungsquelle

- D1: erste Diode
- D2: zweite Diode
- K1: Kathode der ersten Diode
- K2: Kathode der zweiten Diode
- A1: Anode der ersten Diode
- A2: Anode der zweiten Diode

- C1: Kollektor des ersten Insulated Gate Bipolartransistors
- C2: Kollektor des zweiten Insulated Gate Bipolartransistors

- G1: Gate des ersten Insulated Gate Bipolartransistors
- G2: Gate des zweiten Insulated Gate Bipolartransistors
- E1: Emitter des ersten Insulated Gate Bipolartransistors
- E2: Emitter des zweiten Insulated Gate Bipolartransistors
- HE1: Hilfsemitter des ersten Insulated Gate Bipolartran-sistors
- HE2: Hilfsemitter des zweiten Insulated Gate Bipolartran-sistors

- L11: Induktivität
- L12: Induktivität
- L13: Induktivität
- L14: Induktivität
- L15: Induktivität
- L16: Induktivität

- L21: Induktivität
- L22: Induktivität
- L23: Induktivität
- L24: Induktivität
- L27: Induktivität

- 1: Abstand

## Patentansprüche

1. Halbbrückenschaltung bei der ein zwischen zwei Eingangsklemmen (15, 16) anliegendes Eingangssignal (V_{E}) an einem Phasenausgang (P) abgreifbar ist, umfassend
- zwei über jeweils ein zwischen einer Steuerelektrode (G1; G2) und einer Hilfselektrode (HE1; HE2) anliegendes Ansteuersignal ansteuerbare Schalttransistoren (1, 2) und
- zwei Dioden (D1, D2),
wobei
- die erste Eingangsklemme (15) mit einer ersten Elektrode (C1) des ersten Schalttransistors (1) und mit einer Kathode (K1) der ersten Diode (D1) verbunden ist,
- eine zweite Elektrode (E1) des ersten Schalttransistors (1) mit einer Anode (A1) der ersten Diode (D1), über eine Leitung mit dem Phasenausgang (P), mit einer ersten Elektrode (C2) des zweiten Schalttransistors (2) und mit einer Kathode (K2) der zweiten Diode (D2) verbunden ist, und
- eine zweite Elektrode (E2) des zweiten Schalttransistors (2) mit einer Anode (A2) der zweiten Diode (D2) und mit der zweiten Eingangsklemme (16) verbunden ist,
- die Leitung zum Phasenausgang (P) drei in Reihe geschaltete Induktivitäten (L11, L15, L16) und einen Knoten (9) aufweist, der mit der Anode (A1) der ersten Diode (D1) und mit der Hilfselektrode (HE1) des ersten Schalttransistors (1) verbunden ist, und
- eine Induktivität (L11) zwischen der Anode (A1) der ersten Diode (D1) und der zweiten Elektrode (E1) des ersten Schalttransistors (1) angeordnet ist,
**dadurch gekennzeichnet, dass**
- die Anode (A1) der ersten Diode (D1) unmittelbar an der Hilfselektrode (HE1) des ersten Schalttransistors (1) angebunden ist.

2. Halbbrückenschaltung nach Anspruch 1, bei der die Anbindung der Hilfselektrode (HE1) des ersten Schalttransistors (1) an der Leitung zum Phasenausgang (P) bei einem Abstand (1) von der zweiten Elektrode (E1) des ersten Schalttransistors (1) erfolgt, an dem der Wert der in der Verbindungsstrecke zwischen der zweiten Elektrode (E1) des ersten Schalttransistors (1) und der Hilfselektrode (HE1) des ersten Schalttransistors (1) liegenden Induktivität (L11) gerade dem Wert entspricht, der für eine vorgegebene Begrenzung der Abschaltgeschwindigkeit des ersten Schalttransistors (1) durch ei ne induktive Gegenkopplung notwendig ist.

3. Halbbrückenschaltung nach einem der vorangegangenen Ansprüche, bei der die beiden Schalttransistoren Insulated Gate Bipolartransistoren (1, 2) sind.

4. Halbbrückenschaltung nach Anspruch 3, bei der die Insulated Gate Bipolartransistoren (1, 2) vom npn-Typ sind und die ersten Elektroden der Insulated Gate Bipolartransistoren (1, 2) die Kollektor-Elektroden (K1, K2) und die zweiten Elektroden der Insulated Gate Bipolartransistoren (1, 2) die Emitter-Elektroden (E1, E2) sind.

## Claims

1. Half-bridge circuit, in which an input signal (V_{E}) that is applied between two input terminals (15, 16) can be tapped off at a phase output (P), comprising
- two switching transistors (1, 2) which can be driven via a respective drive signal that is applied between a control electrode (G1; G2) and an auxiliary electrode (HE1; HE2), and
- two diodes (D1, D2),
- the first input terminal (15) being connected to a first electrode (C1) of the first switching transistor (1) and to a cathode (K1) of the first diode (D1),
- a second electrode (E1) of the first switching transistor (1) being connected to an anode (A1) of the first diode (D1), to the phase output (P) via a line, to a first electrode (C2) of the second switching transistor (2) and to a cathode (K2) of the second diode (D2), and
- a second electrode (E2) of the second switching transistor (2) being connected to an anode (A2) of the second diode (D2) and to the second input terminal (16),
- the line to the phase output (P) having three series-connected inductances (L11, L15, L16) and a node (9) which is connected to the anode (A1) of the first diode (D1) and to the auxiliary electrode (HE1) of the first switching transistor (1), and
- an inductance (L11) being arranged between the anode (A1) of the first diode (D1) and the second electrode (E1) of the first switching transistor (1),
**characterized in that**
- the anode (A1) of the first diode (D1) is directly connected to the auxiliary electrode (HE1) of the first switching transistor (1).

2. Half-bridge circuit according to Claim 1, in which the auxiliary electrode (HE1) of the first switching transistor (1) is connected to the line to the phase output (P) at a distance (1) from the second electrode (E1) of the first switching transistor (1) at which the value of the inductance (L11) located in the connection path between the second electrode (E1) of the first switching transistor (1) and the auxiliary electrode (HE1) of the first switching transistor (1) corresponds precisely to that value which is required for predetermined limitation of the turn-off speed of the first switching transistor (1) by means of inductive negative feedback.

3. Half-bridge circuit according to one of the preceding claims, in which the two switching transistors are insulated gate bipolar transistors (1, 2).

4. Half-bridge circuit according to Claim 3, in which the insulated gate bipolar transistors (1, 2) are of the npn type, and the first electrodes of the insulated gate bipolar transistors (1, 2) are the collector electrodes (K1, K2) and the second electrodes of the insulated gate bipolar transistors (1, 2) are the emitter electrodes (E1, E2).

## Revendications

1. Circuit en demi-pont, dans lequel un signal (V_{E}) d'entrée s'appliquant entre deux bornes (15, 16) d'entrée peut être prélevé à une sortie (P) de phase, comprenant
- deux transistors (1, 2) de commutation pouvant être commandés par respectivement un signal de commande s'appliquant entre une électrode (G1, G2) de commande et une électrode (HE1, HE2) et
- deux diodes (D1, D2),
dans lequel
- la première borne (15) d'entrée est reliée à une première électrode (C1) du premier transistor (1) de commutation et à une cathode (K1) de la première diode (D1),
- une deuxième électrode (E1) du premier transistor (1) de commutation est reliée à une anode (A1) de la première diode (D1), par une ligne à la première sortie (P) de phase, à une première électrode (C2) du deuxième transistor (2) de commutation et à une cathode (K2) de la deuxième diode (D2), et
- une deuxième électrode (E2) du deuxième transistor (2) de commutation est reliée à une anode (A2) de la deuxième diode (D2) et à la deuxième borne (16) d'entrée,
- la ligne allant à la sortie (P) de phase a trois inductances (L11, L15, L16) montées en série et un noeud (9), qui est relié à l'anode (A1) de la première diode (D1) et à l'électrode (HE1) auxiliaire du premier transistor (1) de commutation, et
- une inductance (L11) est montée entre l'anode (A1) de la première diode (D1) et la deuxième électrode (E1) du premier transistor (1) de commutation,
**caractérisé en ce que**
- l'anode (A1) de la première diode (D1) est reliée directement à l'électrode (HE1) auxiliaire du premier transistor (1) de commutation.

2. Circuit en demi-pont suivant la revendication 1, dans lequel la liaison de l'électrode (HE1) auxiliaire du premier transistor (1) de commutation à la ligne allant à la sortie (P) de phase s'effectue à une distance (1) de la deuxième électrode (E1) du premier transistor (1) de commutation, pour laquelle la valeur de l'inductance (L11) dans la section de liaison entre la deuxième électrode (E1) du premier transistor (1) de commutation et l'électrode (HE1) auxiliaire du premier transistor (1) de commutation correspond exactement à la valeur qui est nécessaire pour une limitation prescrite de la vitesse de coupure du premier transistor (1) de commutation par un contre-couplage inductif.

3. Circuit en demi-pont suivant l'une des revendications précédentes, dans lequel les deux transistors de commutation sont des transistors (1, 2) bipolaires insulated gate.

4. Circuit en demi-pont suivant la revendication 3, dans lequel les transistors (1, 2) bipolaires insulated gate sont du type npn et les premières électrodes des transistors (1, 2) bipolaires insulated gate sont les électrodes (K1, K2) formant collecteur et les deuxièmes électrodes des transistors (1, 2) bipolaires insulated gate sont des électrodes (E1, E2) formant émetteur.
